# EUROPEAN PATENT APPLICATION

(11) **EP 4 489 294 A1**
(43) Date of publication of application: **08.01.2025**
(21) Application number: 23216845.0
(22) Date of filing: 14.12.2023
(51) Int. Cl.: H02P 29/00, G05B 19/042, H02P 27/08, H03K 7/08

(54) **SIGNAL CONTROL METHOD, DEVICE, AND ELECTRONIC APPARATUS**

(30) Priority: 04.07.2023 CN 202310808684
(71) Applicant: Shenzhen Lichi Semiconductor Technology Co. Ltd., Shenzhen (CN)
(72) Inventor: ZHANG, Lihang, Shenzhen (CN); CHEN, Hu, Shenzhen (CN); XIE, Jun, Shenzhen (CN)
(74) Representative: Ziebig Hengelhaupt Intellectual Property Attorneys Patentanwaltskanzlei PartGmbB

(57) **Abstract**

The present application discloses a signal control method, a device and an electronic apparatus, the method comprises: in the case of receiving a first control command to synchronize a plurality of target signals, acquiring a reference signal corresponding to each of the target signals, wherein the value of the reference signal controls waveform changes of the corresponding target signal in an incremental or decremental process; determining, based on the periods of the plurality of reference signals, a reference periodic signal with a synchronization period, wherein the synchronization period is associated with the period of each of the reference signals, and a first reference value in the reference periodic signal is used to instruct to perform a synchronization operation on all of the target signals within the synchronization period; determining, based on the reference periodic signal, a corresponding synchronization instruction to control the target signals to be synchronized within the synchronization period. The method can achieve the control of the synchronization of multi-channel target signals.

## Description

### Field of the invention

The present application relates to the field of signal control, especially relates to a signal control method, a device, and an electronic apparatus.

### Background of the Invention

With the development of electric vehicles, the demand for accuracy in the control of equipment on electric vehicles is increasing. Wherein, in term of control of signal, it is necessary to use pulse width modulation. Pulse width modulation (PWM) can output a pulse signal with variable duty cycle, which can control the on and off of control apparatus (e.g., LED lights, DC motors). PWM can be widely used in control fields such as industrial automobile or the like. In many application scenarios where target signals such as PWM or the like are controlled (e.g., control of DC brushless motors), it is necessary to use the simultaneous outputs of multi-channel PWM to control the settings. However, in this multi-channel PWM scenario, it is necessary to ensure that the multi-channel PWM signals are activated synchronously and remain synchronous throughout the operation process, so as to avoid phase differences due to prolonged operation, which may lead to deviations in the control of the apparatus. However, in the current signal control field, it is usual to control a single PWM, and there is no better way to achieve synchronous control of multi-channel PWM signals.

### Summary of the invention

The embodiments of the present application aims at providing a signal control method, a device, and an electronic apparatus, the method can achieve the synchronous control of multi-channel target signals.

In order to achieve the above purpose, the present application provides a signal control method, which comprises: in the case of receiving a first control command to synchronize a plurality of target signals, acquiring a reference signal corresponding to each of the target signals, wherein the value of the reference signal controls the waveform changes of the corresponding target signals in an incremental or decremental process; determining, based on the period of the plurality of reference signals, a reference periodic signal with a synchronization period, wherein the synchronization period is associated with the period of each of the reference signals, and a first reference value in the reference periodic signal is used to instruct to perform a synchronization operation on all of the target signals within the synchronization period; determining, based on the reference periodic signal, a corresponding synchronization instruction to control the target signal to be synchronized within the synchronization period.

As an option, acquiring a reference signal corresponding to each of the target signals comprises: acquiring, by means of a multiplexer, the reference signal of each target module, wherein the target module is used to output the target signal, there is a second reference value in the reference signal, the second reference value is used to control the timing of the waveform changes of the corresponding target signal.

As an option, determining a reference periodic signal having a synchronization period based on the periods of the plurality of reference signals comprises: determining the least common multiple of the periods of the plurality of reference signals; determining the synchronization period based on the least common multiple.

As an option, determining a corresponding synchronization instruction based on the reference periodic signal comprises: determining a corresponding phase signal based on the reference periodic signal, wherein the phase signal is used to control the synchronization timing of the reference signals; determining the synchronization instruction based on the phase signal and a first control signal corresponding to the first control command.

As an option, determining a corresponding phase signal based on the reference periodic signal comprises: determining a waveform of the phase signal based on the first reference value in the reference periodic signal.

As an option, determining the synchronization instruction based on the phase signal and the first control signal corresponding to the first control command comprises: performing an OR operation on the phase signal and the first control signal; determining the synchronization instruction based on the result of the OR operation.

As an option, controlling the target signal to be synchronized within the synchronization period comprises: sending the synchronization instructions to each of the target modules for outputting the target signal to cause each of the target modules to adjust the corresponding reference signal by means of the synchronization instructions; based on the adjusted reference signal, adjusting the corresponding target signal to synchronize the individual target signals.

As an option, wherein the reference signal and the reference periodic signal have the same working clock.

The present application also provides a signal control device, which comprises: an acquisition module configured to, in the case of receiving a first control command to synchronize a plurality of target signals, acquire a reference signal corresponding to each of the target signals, wherein the value of the reference signal controls the waveform changes of the corresponding target signal in an incremental or decremental process; a determination module configured to determine, based on the periods of the plurality of reference signals, a reference periodic signal with a synchronization period, wherein the synchronization period is associated with the period of each of the reference signals, and a first reference value in the reference periodic signal is used to instruct to perform a synchronization operation on all of the target signals within the synchronization period; a control module configured to determine, based on the reference periodic signal, a corresponding synchronization instruction to control the target signals to be synchronized within the synchronization period.

The present application also provides an electronic apparatus, which comprises a processor and a memory, the memory stores an executable program, the processor executes the executable program to perform the steps of the method as described above.

The advantageous effect of the present application is that: the signal control method enables the accurate control of the synchronization of multi-channel PWM and other target signals, thereby avoiding deviations in the control of the apparatus resulting from phase differences in multi-channel PWM and other target signals due to a prolonged output, while improving the control efficiency.

### Brief Description of the Drawings

Fig.1 is a flowchart for signal control method of an embodiment of the present application;
Fig.2 is a flowchart for an embodiment of step 200 in Fig. 1 of the embodiment of the present application;
Fig.3 is a flowchart for an embodiment of step 300 in Fig. 1 of the embodiment of the present application;
Fig.4 is a flowchart for an embodiment of step 320 in Fig. 3 of the embodiment of the present application;
Fig. 5 is a flowchart for another embodiment of step 300 in Fig. 1 of the embodiment of the present application;
Fig. 6 is a schematic diagram for an embodiment of controlling target signal through reference signal of the embodiment of the present application;
Fig. 7 is a schematic diagram for connection relation between Xtrg module and each target module of the embodiment of the present application;
Fig. 8 is a schematic diagram for waveform comparison among a first control signal, phase signal, synchronizing signal, reference periodic signal and each reference signal in the embodiment of the present application;
Fig. 9 is a structural block diagram for the signal control device of the embodiment of the present application;
Fig. 10 is structural block diagram for the electronic apparatus of the embodiment of the present application.

### Detailed Description of Embodiments

Various aspects and features are described here with reference to the drawings.

It should be understood that various modifications can be made to the embodiments of the present application. Thus, the foregoing specification should not be regarded as limiting, but merely as an example of embodiments. Those skilled in the art can conceive of other modifications within the scope and spirit of the present application.

The drawings included in and forming a part of the specification, illustrate embodiments of the present application and are used to explain the principles of the present application in conjunction with the general description of the present application given above and the detailed description of the embodiments given below.

These and other features of the present application will become apparent by the following description of the preferred form of the embodiments given as non-limiting examples with reference to the drawings.

It should also be understood that although the present application has been described with reference to some examples, many other equivalent forms of the present application can be realized with certainty by those skilled in the art.

The foregoing and other aspects, features and advantages of the present application will become more apparent in view of the following detailed description when combined with the drawings.

Embodiments of the present application hereinafter will be described with reference to the drawings; however, it should be understood that the embodiments applied are merely examples of the present application, which may be implemented in a variety of ways. Familiar and/or repetitive functions and structures are not described in detail to avoid unnecessary or redundant details that would render the present application ambiguous. Accordingly, the specific structural and functional details of the present application herein are not intended to be limiting, but are merely intended to serve as a basis for the claims and as a representative basis for teaching those skilled in the art to use the present application in various ways with any substantially suitable detailed structure.

The specification may use the phrases "in an embodiment", "in another embodiment", "in yet another embodiment", or "in other embodiments", which may refer to one or more of the same or different embodiments according to the present application.

A signal control method of an embodiment of the present application, which can be applied in a field of chip, such as within a chip, or in a first module associated with the chip, such as an Xtrg module. The Xtrg module has a control function that can achieve the synchronous control of multi-channel target signals, such as PWMs, indicator signals.

The method includes: a synchronization operation on the target signal is activated when the first control command is acquired, wherein the first control command may be an instruction to synchronize the target signal, which may be generated by a corresponding trigger module. For example, the output signal of the trigger module changes from a low level to a high level to generate the first control command.

The target signal has a corresponding reference signal, and the reference signal is used to instruct the operation of the corresponding target signal, and can control the waveform changes of the corresponding target signal in an incremental or decremental process. The reference signal has a corresponding period, and can undergo the same waveform change within each period.

Based on the period of the reference signal, a reference periodic signal with a synchronization period is determined. For example, a least common multiple of the periods of all the reference signals can be determined, and the least common multiple can be used as the synchronization period of the reference periodic signals. The synchronization period can be used to instruct all of the target signals to perform waveform changes, the value of the reference periodic signal changes with time accordingly, and when the value of the reference periodic signal gradually increases to a first reference value, a corresponding synchronization instruction can be triggered to be generated to control the target signals to be synchronized within the synchronization period.

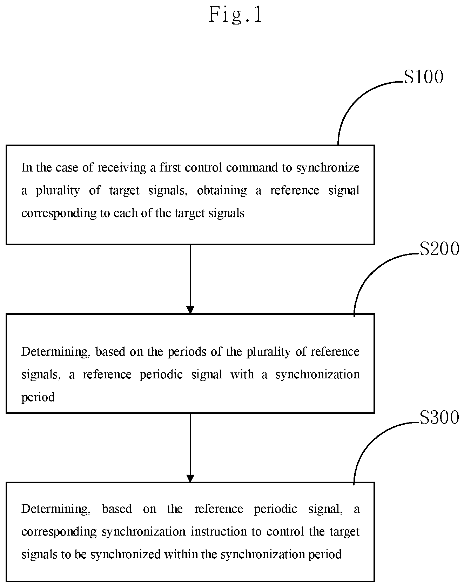

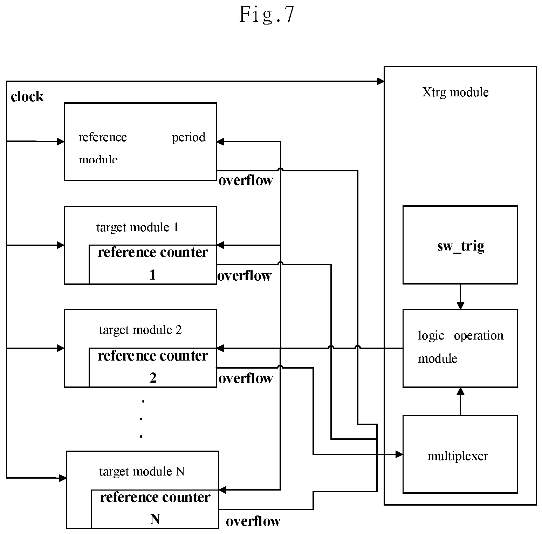

The signal control method is described in detail below in conjunction with the drawings. Fig. 1 is a flowchart for signal control method of the embodiment of the present application, as shown in FIG. 1 and in conjunction with FIG. 7, the method includes the following steps.

S 100, in the case that a first control command to synchronize a plurality of target signals is received, a reference signal corresponding to each of the target signals is acquired, wherein the value of the reference signal controls the waveform changes of the corresponding target signal in an incremental or decremental process.

Exemplarily, the signal control method of the present embodiment may be applied in a first module, such as in an Xtrg module. The Xtrg module is connected with a plurality of target modules, each of the target modules outputs a respective target signal, and the Xtrg module is capable of controlling all the target signals for synchronization.

The Xtrg module includes a plurality of functional sub-modules, such as trigger modules, logic operation modules and multiplexers. Each of these sub-modules has its own function and can cooperate with each other to synchronize the target signals.

The target signal is the target for controlling the synchronization thereof, e.g., the target signal may be a Pulse width modulation (PWM) output from a target module (e.g., a PWM module). The first control command is used to control all of the target signals to be synchronized. For example, a plurality of target modules respectively output their own PWMs, and each PWM can be controlled by a reference signal (reference counter) generated by the corresponding target module. A first control command is used to control the synchronization of all PWMs. When the trigger module generates the first control command, the synchronization operation of the target signals can be activated.

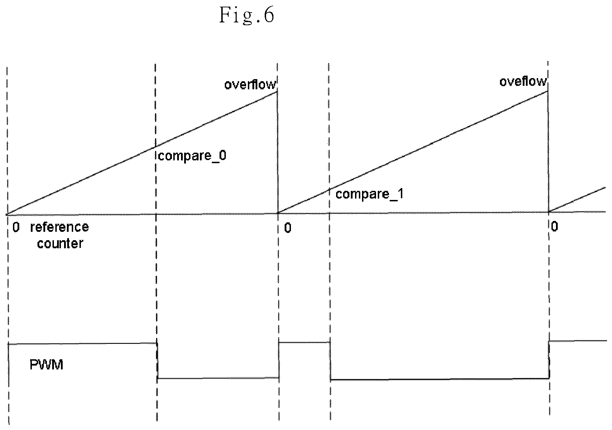

A reference signal corresponding to each target signal is acquired through the multiplexer, and the value of the reference signal controls the waveform changes of the corresponding target signal in the incremental or decremental process. In conjunction with FIG. 6, for example, when the value of the reference signal (reference counter) increases from 0 to a comparison value (compare value), the waveform of the PWM signal is controlled to transition from a high level to a low level. The value of the reference signal continues to increase, and when the value increases from the comparison value (compare value) to a first reference value (overflow value), the waveform of the PWM signal is transitioned from a low level to a high level and a new period is started, while the value of the reference signal is adjusted to 0 and then gradually increased from 0.

S200, based on the periods of a plurality of reference signals, a reference periodic signal with a synchronization period is determined, wherein the synchronization period is associated with the period of each of the reference signals, and a first reference value in the reference periodic signal is used to instruct to perform a synchronization operation on all of the target signals within the synchronization period.

Exemplarily, the reference periodic signal (sync time counter) may be used to indicate changes in all of the reference signals, thereby may indirectly control the waveform changes of the target signals corresponding to all of the reference signals.

The waveform of the reference periodic signal may be determined based on the waveforms of the reference signals. For example, the multiplexer sends, to the logic operation module, relevant information of the acquired reference signal corresponding to each target signal, including a period of the reference signal, a second reference value of the reference signal (an overflow value of the reference signal), and the like. The logic operation module may determine a synchronization period of the reference periodic signal based on the periods of all the reference signals.

In an embodiment, the logic operation module may determine a least common multiple of the periods of all the reference signals, and determine the least common multiple as a synchronization period of the reference periodic signal. If there is no reference signal that has a period of the least common multiple among all the reference signals, a reference periodic signal may be newly generated, whose synchronization period is the least common multiple as described above. When there is a reference signal with a period that is the least common multiple among all the reference signals, the reference signal may be determined as a reference periodic signal.

In another embodiment, a common multiple (which may be a non-least common multiple) of the periods of all the reference signals may be determined, the common multiple may be determined as the synchronization period of the reference periodic signals, and thereby determining the reference periodic signal.

The reference periodic signal has a synchronization period, and at the end time of the synchronization period, the value of each reference signal can be controlled to be adjusted to 0, so as to control the synchronization of the corresponding individual target signals. Specifically, within the synchronization period, the value of the reference periodic signal increases with time, and when a first reference value (overflow value) of the reference periodic signal is reached, it can indicate the end of the period of each reference signal and a change in the waveform is to occur, so that the value of each reference signal is adjusted to 0, which will indicate that a change in the waveform of each corresponding target signals occurs at the same time, e.g., it will from a low potential to a high potential at the same time. This enables all target signals to perform the synchronization operation.

S300, based on the reference periodic signal, a corresponding synchronization instruction is determined to control the target signals to be synchronized within the synchronization period.

Exemplarily, the reference periodic signal (sync time counter) has an indicative function and can be used to control the synchronization of the individual reference signals and thus to indicate the synchronization operation of the corresponding target signals. The reference periodic signal has a corresponding synchronization period, and at the end of a synchronization period, the reference periodic signal will enter another new synchronization period. The present embodiment can construct a corresponding control signal based on the synchronization period of the reference periodic signal, and the control signal generates a corresponding synchronization instruction when the synchronization period is about to end, such as a change of the control signal from a low potential to a high potential, thereby forming a synchronization instruction. The logic operation module in the Xtrg module sends the synchronization instruction to each target module, so that each target module responds to the synchronization instruction, and adjusts the output target signal (e.g., PWM) from a low potential to a high potential at the same time, thus realizing the synchronization of the target signals.

In another embodiment, since the synchronization instruction can adjust the timing of the change of the high and low potentials of the target signals while controlling the synchronization of the individual target signals, it is possible to achieve the control of the duty cycle of the target signals.

The signal control method of the embodiments of the present application can accurately control the synchronization of the multi-channel PWM and other target signals, thereby avoiding deviations in the control of the apparatus resulting from phase differences in the multi-channel PWM and other target signals due to a prolonged output, while improving the control efficiency.

In an embodiment of the present application, acquiring a reference signal corresponding to each target signal comprises the following step.

The reference signal of each target module is acquired by means of a multiplexer, wherein the target module is used to output the target signal, there is a second reference value in the reference signal, the second reference value is used to control the timing of waveform changes in the corresponding target signal.

Exemplarily, the Xtrg module includes a multiplexer (Mux), which is connected to the logic operation module and each of the target modules, and by means of the multiplexer, a reference signal (reference counter) that each target module has can be acquired. The reference signal can be changed accordingly in its period, for example, as the time increases, the value of the reference signal will increase. When the value of the reference signal increases to the second reference value (overflow value of the reference signal), the corresponding target signal can be instructed to change the waveform.

For example, when the value of all the reference signals increases to the overflow value of the reference signal at the same time, each target signal will transition from low potential to high potential at the same time, and then enter a new period. The synchronization of all target signals is achieved.

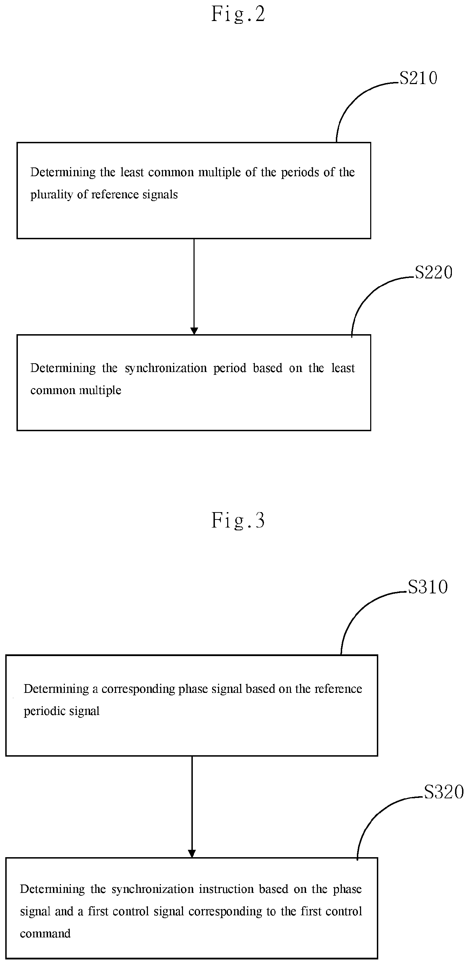

In an embodiment of the present application, determining a reference periodic signal with a synchronization period based on the periods of the plurality of reference signals, as shown in FIG. 2, comprises the following steps.
S210, the least common multiple of the periods of the plurality of reference signals is determined;
S220, the synchronization period is determined based on the least common multiple.

Exemplarily, each reference signal has its corresponding period, and corresponding waveform changes can be made in each period, and the waveform changes are repeated in another period. Based on the periods of the plurality of reference signals, a reference periodic signal (sync time counter) with a synchronization period is determined. This reference periodic signal can indicate the waveform changes of each target signal using its synchronization period.

In the present embodiment, when determining the synchronization period, it is first necessary to determine a least common multiple of the periods of the plurality of reference signals. On one hand, when the period of one of the reference signals is the least common multiple of the periods of all the reference signals, the reference signal may be determined as a reference periodic signal, and the period of the reference signal is determined as the synchronization period of the reference periodic signal. On the other hand, when the periods of all of the reference signals are not the least common multiple of the periods of the other reference signals, a reference periodic signal may be regenerated based on the least common multiple, wherein the synchronization period of the generated reference periodic signal is the least common multiple as described above.

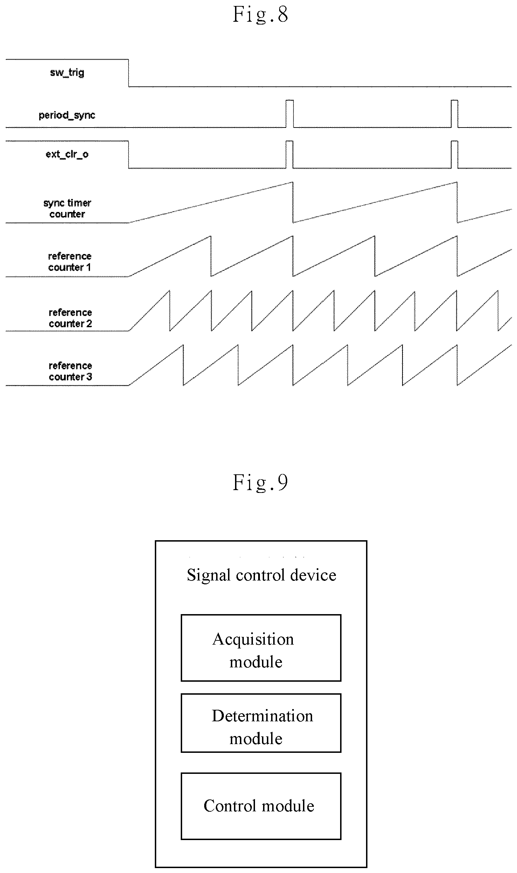

For example, in conjunction with Fig. 8, the period of the first reference signal (reference counter 1) is 300ns, the period of the second reference signal (reference counter 2) is 150ns, and the period of the third reference signal (reference counter 3) is 200ns, thus the least common multiple of the individual periods is 600ns, and 600ns can be determined as the synchronization period of the reference periodic signal, and thus determining the reference periodic signal.

For another example, the period of the first reference signal (reference counter 1) is 600ns, the period of the second reference signal (reference counter 2) is 150ns, and the period of the third reference signal (reference counter 3) is 200ns, thus the least common multiple of the periods is 600ns, and 600ns can be determined as the synchronization period of the reference periodic signal, and thus determining the reference periodic signal.

In an embodiment of the present application, as shown in Fig. 3, determining a corresponding synchronization instruction based on the reference periodic signal comprises the following steps.

S310, based on the reference periodic signal, a corresponding phase signal is determined, wherein the phase signal is used to control the synchronization timing of the reference signals.

Exemplarily, a waveform of a phase signal (period_sync) is determined based on the reference periodic signal, and the control of the synchronization timing of the reference signal is achieved by the waveform changes of the phase signal.

Specifically, a corresponding phase signal is determined based on a synchronization period of the reference periodic signal and/or a first reference value of the reference periodic signal. For example, the phase signal may be at a low potential for most of the time within the synchronization period and at a high potential for a shorter time when the synchronization period is about to end. Synchronization control of the reference signal is performed during the transition from the low potential to the high potential.

S320, the synchronization instruction is determined based on the phase signal and a first control signal corresponding to the first control command.

Exemplarily, the trigger module (sw_trig module) may output a first control signal (sw_trig), and the first control signal (sw_trig) may form the first control command through the waveform transformation for synchronizing the target signal.

In the present embodiment, the synchronization instruction is determined based on the phase signal (period_sync) as well as the first control signal (sw_trig). For example, when the first control signal is in a first state, the synchronization instruction is determined based on the fluctuation of the waveform of the phase signal, wherein the first state characterizes that the first module (e.g., the Xtrg module), which is the target, is still in the phase of the synchronization operation.

In an embodiment of the present application, determining a corresponding phase signal based on the reference periodic signal comprises the following step.

The waveform of the phase signal is determined based on the first reference value in the reference periodic signal.

Exemplarily, the value of reference periodic signal increases with time, and when it reaches the first reference value, it indicates that the individual reference signals need to be synchronized at that time. In this embodiment, the waveform of the phase signal may be determined based on the first reference value in the reference periodic signal, such that the determined waveform can form a synchronization instruction, thereby synchronizing the individual reference signals.

In an embodiment, the phase signal is at a low potential for most of the synchronization period, and when the value of the reference periodic signal changes to the first reference value, the phase signal transitions from a low potential to a brief high potential, thereby determining the waveform of the phase signal within the synchronization period.

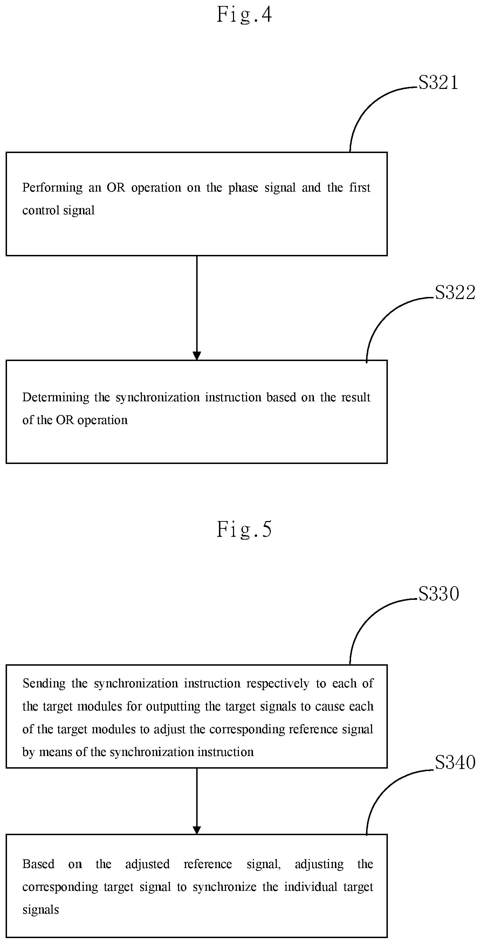

In an embodiment of the present application, determining the synchronization instruction based on the phase signal and the first control signal corresponding to the first control command, as shown in Fig. 4 and in conjunction with Fig. 8, comprises the following steps.

S321, an OR operation is performed on the phase signal and the first control signal.

S322, the synchronization instruction is determined based on the result of the OR operation.

Exemplarily, an OR operation is performed on the phase signal (period_sync) and the first control signal (sw_trig), i.e., an operation of "phase signal OR first control signal", wherein when one or both of period_sync and sw_trig are "1" (high level), the result of the OR operation is "1" (high potential). For example, if sw_trig is always at a low potential "0" during the synchronization process, and period_sync transitions from a low potential "0" to a high potential "1", when the synchronization period is about to end, "1" will be obtained after performing an OR operation on both of them. Thus, the potential change is realized, the corresponding synchronization instruction is formed, and the synchronization signal ext_clr_o can be used to indicate the synchronization instruction, i.e., the reference signals are synchronized at the end of the current synchronization period.

In an embodiment of the present application, controlling the target signal to be synchronized within the synchronization period, as shown in Fig. 5, comprises:
S330, the synchronization instruction is respectively sent to each of the target modules for outputting the target signal to cause each of the target modules to adjust the corresponding reference signal by means of the synchronization instructions.

Exemplarily, the logic operation module is connected with a target module and further connected with a reference period module. Wherein the reference period module is used to output a reference periodic signal (sync time counter), and the target module is used to output a target signal. For example, as shown in FIG. 8, the target module 1 outputs PWM1 based on the reference counter 1, the target module 2 outputs PWM2 based on the reference counter 2, the target module 3 outputs PWM3 based on the reference counter 3...and the target module N outputs PWMN based on the reference signal N.

The logic operation module can respectively send synchronization instructions to each target module and send the synchronization instructions to the reference period module via the synchronization signal ext_clr_o. The target modules and the reference periodic signals adjust the corresponding reference signal (reference counter) and output the waveform of the reference periodic signal (sync time counter) by means of the synchronization instructions.

S340, based on the adjusted reference signal, the corresponding target signal is adjusted to synchronize the individual target signals.

Exemplarily, the adjusted reference signals can control the target signals to perform a synchronization operation at a first reference value in the reference periodic signals within the synchronization period, so that the waveforms of the individual target signals change at the same time in the same way. For example, the individual PWMs simultaneously transition from a low potential to a high potential and a new period starts.

In an embodiment of the present application, wherein the reference signal and the reference periodic signal have the same working clock.

Exemplarily, the reference signal, the reference periodic signal, and the Xtrg module associated with the chip may all have the same working clock (clock), so that all associated circuits work in a synchronous clock mode without any asynchronous circuits and without the uncertainties that asynchronous circuits may bring.

Embodiments of the present application also provide a signal control device that can be applied to a chip or a first module associated with the chip, as shown in Fig. 9, the device comprises an acquisition module, a determination module, and a control module.

The acquisition module is configured to acquire a reference signal corresponding to each of the target signals in the case of receiving a first control command to synchronize the plurality of target signals, wherein the value of the reference signal controls the waveform changes of the corresponding target signal in an incremental or decremental process.

Exemplarily, the control device may be applied to a chip or a first module associated with the chip, such as to an Xtrg module, which is connected with a plurality of target modules, each of the target modules outputs a respective target signal, and the Xtrg module is capable of controlling all the target signals to perform synchronization.

The Xtrg module includes a plurality of functional sub-modules, such as trigger modules, logic operation modules and multiplexers, wherein each of these sub-modules has its own function and can cooperate with each other to achieve the synchronization of the target signals.

The target signal is the target for controlling the synchronization thereof, e.g., the target signal may be a Pulse width modulation (PWM) output from a target module (e.g., a PWM module). The first control command is used to control all of the target signals to be synchronized. For example, a plurality of target modules respectively output their own PWMs, and each PWM can be controlled by a reference signal (reference counter) generated by the corresponding target module. A first control command is used to control the synchronization of all PWMs. When the trigger module generates the first control command, the synchronization operation of the target signals can be activated.

The acquisition module acquires the reference signal corresponding to each target signal by means of the multiplexer, and the value of the reference signal controls the waveform changes of the corresponding target signal in the incremental or decremental process. For example, when the value of the reference signal (reference counter) increases from 0 to the comparison value (compare value), the waveform of the PWM signal is controlled to transition from a high level to a low level; the value of the reference signal continues increasing, and when the value of the reference signal increases from the comparison value (compare value) to the first reference value (overflow value), the waveform of the PWM signal transitions from a low level to a high level and a new period starts, while the value of the reference signal is adjusted to 0, and then gradually increases from 0.

The determination module is configured to determine, based on the periods of the plurality of reference signals, a reference periodic signal with a synchronization period, wherein the synchronization period is associated with the period of each of the reference signals, and the first reference value in the reference periodic signal is used to instruct to perform a synchronization operation on all of the target signals within the synchronization period.

Exemplarily, a reference periodic signal (sync time counter) may be used to indicate changes in all of the reference signals, thereby may indirectly control the waveform changes of the target signals corresponding to all of the reference signals.

The determination module may determine a waveform of the reference periodic signal based on the waveform of each reference signal. For example, the multiplexer sends, to the logic operation module, information related to the reference signal corresponding to each target signal acquired, including a period of the reference signal, a second reference value of the reference signal (an overflow value of the reference signal), or the like. The determination module, using the logic operation module, can determine a synchronization period of the reference periodic signal based on the periods of all the reference signals.

In an embodiment, the determination module, using the logic operation module, can determine a least common multiple of the periods of all the reference signals, and determine the least common multiple as a synchronization period of the reference periodic signal. And if there is no reference signal that has a period of the least common multiple among all the reference signals, a new reference periodic signal can be generated, whose synchronization period is the least common multiple as described above. When there is a reference signal with a period that is the least common multiple among all the reference signals, the reference signal may be determined as the reference periodic signal.

In another embodiment, the determination module may determine a common multiple (which may be a non-least common multiple) of the periods of all the reference signals, determine the common multiple as a synchronization period of the reference periodic signals, and thereby determine the reference periodic signals.

The reference periodic signal has a synchronization period, and at the end time of the synchronization period, the value of each reference signal can be controlled to be adjusted to 0, so as to control the synchronization of the corresponding individual target signals. Specifically, within the synchronization period, the value of the reference periodic signal increases with time, and when the first reference value (overflow value) of the reference periodic signal is reached, it can indicate the end of the period of each reference signal and a change in the waveform is to occur, so that the value of each reference signal is adjusted to 0, which will indicate that a change in the waveform of each corresponding target signal occurs at the same time, e.g., it will change from a low potential to a high potential at the same time. This enables all target signals to perform the synchronization operation.

The control module is configured to determine, based on the reference periodic signal, a corresponding synchronization instruction to control the target signals to be synchronized within the synchronization period.

Exemplarily, the reference periodic signal (sync time counter) has an indicative function and can be used to control the synchronization of the individual reference signals and thus to indicate the synchronization operation of the corresponding target signals. The reference periodic signal has a corresponding synchronization period, and at the end of a synchronization period, the reference periodic signal will enter another new synchronization period. The control module of this embodiment may construct a corresponding control signal based on the synchronization period of the reference periodic signal, and the control signal generates a corresponding synchronization instruction when the synchronization period is about to end, such as a change of the control signal from a low potential to a high potential, thereby forming a synchronization instruction. The logic operation module in the Xtrg module is used to send the synchronization instruction to each target module, so that each target module responds to the synchronization instruction, and adjusts the output target signal (e.g., PWM) from a low potential to a high potential at the same time, thereby realizing the synchronization of the target signals.

In another embodiment, since the synchronization instruction can adjust the timing of the change of the high and low potentials of the target signals while controlling the synchronization of the individual target signals, the control module can achieve the control of the duty cycle of the target signals.

In an embodiment of the present application, the acquisition module is further configured to: acquire, by means of a multiplexer, the reference signal of each target module, wherein the target module is used to output the target signal, there is a second reference value in the reference signal, the second reference value is used to control the timing of the waveform changes in the corresponding target signal.

In an embodiment of the present application, the determination module is further configured to: determine the least common multiple of the periods of the plurality of reference signals; determine the synchronization period based on the least common multiple.

In an embodiment of the present application, the control module is further configured to: determine, based on the reference periodic signal, a corresponding phase signal, wherein the phase signal is used to control the synchronization timing of the reference signal; determine the synchronization instruction based on the phase signal and a first control signal corresponding to the first control command.

In an embodiment of the present application, the control module is further configured to: determine a waveform of the phase signal based on a first reference value in the reference periodic signal.

In an embodiment of the present application, the control module is further configured to: perform an OR operation on the phase signal and the first control signal; determine the synchronization instruction based on the result of the OR operation.

In an embodiment of the present application, the control module is further configured to: send the synchronization instruction respectively to each of the target modules for outputting the target signal, so as to cause each of the target modules to adjust the corresponding reference signal by means of the synchronization instruction; based on the adjusted reference signal, adjust the corresponding target signal to synchronize the target signals.

In an embodiment of the present application, the reference signal and the reference periodic signal have the same working clock.

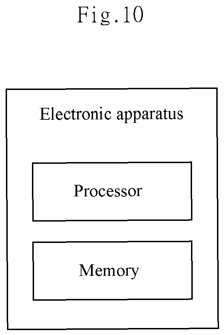

Embodiments of the present application also provide an electronic apparatus, as shown in Fig. 10, which comprises a processor and a memory, the memory stores an executable program, the processor executes the executable program to perform the steps of the method as described above.

Embodiments of the present application also provide a storage medium, the storage medium carries one or more computer programs. When the one or more computer programs are executed by a processor, the steps of the method as described above are achieved.

It should be understood that in embodiments of the present application, the processor may be a Central Processing Unit (CPU), which may also be another general purpose processor, Digital Signal Processing (DSP), Application Specific Integrated Circuit (ASIC), Field-Programmable Gate Array (FPGA), or other programmable logic devices, discrete gates or transistor logic devices, discrete hardware components, or the like.

It should also be understood that the memory mentioned in embodiments of the present application may be volatile memory or non-volatile memory, or may include both volatile and non-volatile memory. Wherein, the non-volatile memory may be Read Only Memory (ROM), Programmable Read Only Memory (PROM), Erasable Programmable Read Only Memory (EPROM), Electrically Erasable Programmable Read Only Memory (EEPROM) or flash memory. The volatile memory may be Random Access Memory (RAM), which is used as an external cache. By way of exemplary, but not limiting, illustration, many forms of RAM are available, such as Static Random Access Memory (SRAM), Dynamic Random Access Memory (DRAM), Synchronous DRAM (SDRAM), Double Data Rate SDRAM (DDR SDRAM), Enhanced Synchronous Dynamic Random Access Memory (ESDRAM), Synchlink DRAM (SLDRAM), and Direct Rambus Random Access Memory (DR RAM).

It should be noted that when the processor is a general-purpose processor, a DSP, an ASIC, an FPGA or other programmable logic device, a discrete gate or transistor logic device, or a discrete hardware component, the memory (storage module) is integrated into the processor.

It should be noted that the memory described herein is intended to include, but is not limited to, these and any other suitable types of memory.

It should also be understood that the first, second, third, fourth, and various numerical numbers referred to herein are only distinguished for the convenience of description and are not intended to limit the scope of the present application.

It should be understood that the term "and/or" herein is merely a description of an association relationship of associated objects, indicating that three types of relationships may exist, e.g., A and/or B, which may express: A alone, both A and B, and B alone. In addition, the character "/" herein generally indicates an "or" relationship between the associated objects before and after it.

In the realization process, the steps of the method as described above may be accomplished by integrated logic circuits of hardware in the processor or instructions in the form of software. The steps of the method disclosed in conjunction with embodiments of the present application may be directly embodied as being accomplished by the hardware processor, or by a combination of hardware and software modules in the processor. The software module may be located in random memory, flash memory, read-only memory, programmable read-only memory or electrically erasable programmable memory, registers, and other storage media well-established in the art. The storage medium is located in a memory, and the processor reads the information in the memory and completes the steps of the method as described above in conjunction with its hardware. To avoid repetition, they are not described in detail herein.

In various embodiments of the present application, the magnitude of the serial number of each of the above processes does not imply the order of execution, and the order of execution of each process shall be determined by its function and inherent logic without constituting any limitation on the process of implementing the embodiments of the present application.

Those skilled in the art may realize that the various illustrative logic blocks (ILBs) and steps described in conjunction with the embodiments disclosed herein can be implemented in electronic hardware, or a combination of computer software and electronic hardware. Whether these functions are performed in hardware or software depends on the particular application and design constraints of the technical solution. Those skilled in the art may use different methods to implement the described functions for each particular application, but such implementations should not be considered as going beyond the scope of this application.

In the several embodiments provided in the present application, it should be understood that the disclosed signal control method, device and electronic apparatus, can be realized in other ways. For example, the above-described embodiments of the device are merely schematic, e.g., the division of the described units, which is merely a logical functional division, may be divided in other ways when actually implemented. For example, multiple units or components may be combined or may be integrated into another system, or some features may be ignored, or not executed. Another point is that the mutual coupling or direct coupling or communication connection as shown or discussed may be an indirect coupling or communication connection through some interfaces, devices or units, which may be electrical, mechanical, or other forms.

The units illustrated as separated components may or may not be physically separated, and components displayed as units may or may not be physical units, i.e., they may be located in one place, or they may be distributed to a plurality of network units. Some or all of these units may be selected to fulfill the purpose of this embodiment scheme according to actual needs.

In addition, each functional unit in various embodiments of the present application may be integrated into a single processing unit, or each unit may physically exist separately, or two or more units may be integrated in a single unit.

In the above embodiments, it may be implemented in whole or in part by software, hardware, firmware, or any combination thereof. When implemented using software, it may be implemented in whole or in part in the form of a computer program product. The computer program product comprises one or more computer instructions. When the computer program instructions are loaded and executed on a computer, the process or function described in accordance with the embodiments of the present application is generated in whole or in part. The computer may be a general-purpose computer, a dedicated computer, a computer network, or other programmable device. The computer instructions may be stored in a computer-readable storage medium or transmitted from one computer-readable storage medium to another computer-readable storage medium. For example, the computer instructions may be transmitted, by wired (e.g., coaxial cable, fiber optic, digital subscriber line) or wireless (e.g., infrared, wireless, microwave, etc.) means, from one website site, computer, server, or data center to another website site, computer, server, or data center. The computer-readable storage medium may be any usable medium that can be accessed by a computer, or a data storage device, such as a server, data center, etc., which integrates one or more usable media. The usable medium may be a magnetic medium, (e.g., floppy disk, hard disk, tape), an optical medium (e.g., DVD), or a semiconductor medium (e.g., a solid state drive), or the like.

What are mentioned above is only embodiments of the present application, but the protection scope of the present application is not limited thereto, and any variation or substitution within the technical scope disclosed in the present application, which can be easily conceived of by those skilled in the art who is familiar with the technical field, shall be covered within the protection scope of the present application. Therefore, the protection scope of the present application shall be subject to the protection scope of the stated claims.

## Claims

1. A signal control method, wherein comprising:
in the case of receiving a first control command to synchronize a plurality of target signals, acquiring a reference signal corresponding to each of the target signals, wherein the value of the reference signal controls waveform changes of the corresponding target signal in an incremental or decremental process;
determining, based on the periods of the plurality of reference signals, a reference periodic signal with a synchronization period, wherein the synchronization period is associated with the period of each of the reference signals, and a first reference value in the reference periodic signal is used to instruct to perform a synchronization operation on all of the target signals within the synchronization period;
determining, based on the reference periodic signal, a corresponding synchronization instruction to control the target signals to be synchronized within the synchronization period.

2. The signal control method according to claim 1, wherein acquiring a reference signal corresponding to each of the target signals comprises:
acquiring, by means of a multiplexer, the reference signal of each target module, wherein the target module is used to output the target signal, there is a second reference value in the reference signal, the second reference value is used to control the timing of waveform changes of the corresponding target signal.

3. The signal control method according to claim 1, wherein determining a reference periodic signal with a synchronization period based on the periods of the plurality of reference signals comprises:
determining the least common multiple of the periods of the plurality of reference signals;
determining the synchronization period based on the least common multiple.

4. The signal control method according to claim 1, wherein determining, based on the reference periodic signal, a corresponding synchronization instruction comprises:
determining a corresponding phase signal based on the reference periodic signal, wherein the phase signal is used to control the synchronization timing of the reference signals;
determining the synchronization instruction based on the phase signal and a first control signal corresponding to the first control command.

5. The signal control method according to claim 4, wherein determining a corresponding phase signal based on the reference periodic signal comprises:
determining a waveform of the phase signal based on the first reference value in the reference periodic signal.

6. The signal control method according to claim 4, wherein determining the synchronization instruction based on the phase signal and the first control signal corresponding to the first control command comprises:
performing an OR operation on the phase signal and the first control signal;
determining the synchronization instruction based on the result of the OR operation.

7. The signal control method according to claim 1, wherein controlling the target signals to be synchronized within the synchronization period comprises:
sending the synchronization instruction respectively to each of the target modules for outputting the target signals to cause each of the target modules to adjust the corresponding reference signal by means of the synchronization instruction;
based on the adjusted reference signal, adjusting the corresponding target signal to synchronize the individual target signals.

8. The signal control method according to claim 1, wherein the reference signal and the reference periodic signal have the same working clock.

9. A signal control device, wherein comprising:
an acquisition module configured to, in the case of receiving a first control command to synchronize a plurality of target signals, acquire a reference signal corresponding to each of the target signals, wherein the value of the reference signal controls waveform changes of the corresponding target signal in an incremental or decremental process;
a determination module configured to determine, based on the periods of the plurality of reference signals, a reference periodic signal with a synchronization period, wherein the synchronization period is associated with the period of each of the reference signals, and a first reference value in the reference periodic signal is used to instruct to perform a synchronization operation on all of the target signals within the synchronization period;
a control module configured to determine, based on the reference periodic signal, a corresponding synchronization instruction to control the target signals to be synchronized within the synchronization period.

10. The signal control device according to claim 9, wherein the acquisition module is further configured to:
acquire, by means of a multiplexer, the reference signal of each target module, wherein the target module is used to output the target signal, there is a second reference value in the reference signal, the second reference value is used to control the timing of waveform changes in the corresponding target signal.

11. The signal control device according to claim 9, wherein, the determination module is further configured to:
determine the least common multiple of the periods of the plurality of reference signals;
determine the synchronization period based on the least common multiple.

12. The signal control device according to claim 9, wherein, the control module is further configured to:
determine a corresponding phase signal based on the reference periodic signal, wherein the phase signal is used to control the synchronization timing of the reference signals;
determine the synchronization instruction based on the phase signal and a first control signal corresponding to the first control command.

13. The signal control device according to claim 12, wherein, the control module is further configured to:
determine a waveform of the phase signal based on the first reference value in the reference periodic signal.

14. The signal control device according to claim 12, wherein, the control module is further configured to:
perform an OR operation on the phase signal and the first control signal;
determine the synchronization instruction based on the result of the OR operation.

15. An electronic apparatus, wherein comprising a processor and a memory, the memory stores an executable program, the processor executes the executable program to perform the steps of the method according to any one of claims 1 to 8.

## Amended claims

### Amended claims in accordance with Rule 137(2) EPC.

1. A signal control method, wherein comprising:
in the case of receiving a first control command to synchronize a plurality of target signals, acquiring a reference signal corresponding to each of the target signals, wherein the value of the reference signal controls waveform changes of the corresponding target signal in an incremental or decremental process (S100);
determining (S200), based on the periods of the plurality of reference signals, a reference periodic signal with a synchronization period, wherein the synchronization period is associated with the period of each of the reference signals, and a first reference value in the reference periodic signal is used to instruct to perform a synchronization operation on all of the target signals within the synchronization period;
determining (S300), based on the reference periodic signal, a corresponding synchronization instruction to control the target signals to be synchronized within the synchronization period, wherein each of the target signals is a pulse width modulation, PWM, signal; wherein
controlling, by the value of the reference signal, waveform changes of the corresponding target signal in an incremental or decremental process comprises:
when the value of the reference signal increases from 0 to a comparison value, the waveform of the PWM signal is controlled to transition from a high level to a low level;
the value of the reference signal continues to increase; and
when the value of the reference signal increases from the comparison value to a reference value, the waveform of the PWM signal is transitioned from a low level to a high level and a new period is started, while the value of the reference signal is adjusted to 0 and then gradually increased from 0.

2. The signal control method according to claim 1, wherein acquiring a reference signal corresponding to each of the target signals (S100) comprises: acquiring, by means of a multiplexer, the reference signal of each target module, wherein the target module is used to output the target signal, there is a second reference value in the reference signal, the second reference value is used to control the timing of waveform changes of the corresponding target signal.

3. The signal control method according to claim 1, wherein determining a reference periodic signal with a synchronization period based on the periods of the plurality of reference signals (S200) comprises:
determining the least common multiple of the periods of the plurality of reference signals (S210);
determining the synchronization period based on the least common multiple (S220).

4. The signal control method according to claim 1, wherein determining (S300), based on the reference periodic signal, a corresponding synchronization instruction comprises:
determining a corresponding phase signal based on the reference periodic signal, wherein the phase signal is used to control the synchronization timing of the reference signals (S310);
determining the synchronization instruction based on the phase signal and a first control signal corresponding to the first control command (S320).

5. The signal control method according to claim 4, wherein determining a corresponding phase signal based on the reference periodic signal (S310) comprises:
determining a waveform of the phase signal based on the first reference value in the reference periodic signal.

6. The signal control method according to claim 4, wherein determining the synchronization instruction based on the phase signal and the first control signal corresponding to the first control command (S320) comprises:
performing an OR operation on the phase signal and the first control signal (S321);
determining the synchronization instruction based on the result of the OR operation (S322).

7. The signal control method according to claim 1, wherein controlling the target signals to be synchronized within the synchronization period (S300) comprises:
sending the synchronization instruction respectively to each of the target modules for outputting the target signals to cause each of the target modules to adjust the corresponding reference signal by means of the synchronization instruction (S330);
based on the adjusted reference signal, adjusting the corresponding target signal to synchronize the individual target signals (S340).

8. The signal control method according to claim 1, wherein the reference signal and the reference periodic signal have the same working clock.

9. A signal control device, wherein comprising:
an acquisition module configured to, in the case of receiving a first control command to synchronize a plurality of target signals, acquire a reference signal corresponding to each of the target signals, wherein the value of the reference signal controls waveform changes of the corresponding target signal in an incremental or decremental process (S 100);
a determination module configured to determine, based on the periods of the plurality of reference signals, a reference periodic signal with a synchronization period, wherein the synchronization period is associated with the period of each of the reference signals, and a first reference value in the reference periodic signal is used to instruct to perform a synchronization operation on all of the target signals within the synchronization period (S200);
a control module configured to determine, based on the reference periodic signal, a corresponding synchronization instruction to control the target signals to be synchronized within the synchronization period (S300), wherein each of the target signals is a pulse width modulation, PWM, signal; wherein
the acquisition module is configured to:
when the value of the reference signal increases from 0 to a comparison value, the waveform of the PWM signal is controlled to transition from a high level to a low level;
the value of the reference signal continues to increase; and
when the value of the reference signal increases from the comparison value to a reference value, the waveform of the PWM signal is transitioned from a low level to a high level and a new period is started, while the value of the reference signal is adjusted to 0 and then gradually increased from 0.

10. The signal control device according to claim 9, wherein the acquisition module is further configured to:
acquire, by means of a multiplexer, the reference signal of each target module, wherein the target module is used to output the target signal, there is a second reference value in the reference signal, the second reference value is used to control the timing of waveform changes in the corresponding target signal.

11. The signal control device according to claim 9, wherein, the determination module is further configured to:
determine the least common multiple of the periods of the plurality of reference signals (S210);
determine the synchronization period based on the least common multiple (S220).

12. The signal control device according to claim 9, wherein, the control module is further configured to:
determine a corresponding phase signal based on the reference periodic signal, wherein the phase signal is used to control the synchronization timing of the reference signals (S310);
determine the synchronization instruction based on the phase signal and a first control signal corresponding to the first control command (S320).

13. The signal control device according to claim 12, wherein, the control module is further configured to:
determine a waveform of the phase signal based on the first reference value in the reference periodic signal.

14. The signal control device according to claim 12, wherein, the control module is further configured to:
perform an OR operation on the phase signal and the first control signal (S321);
determine the synchronization instruction based on the result of the OR operation (S322).

15. An electronic apparatus, wherein comprising a processor and a memory, the memory stores an executable program, the processor executes the executable program to perform the steps of the method according to any one of claims 1 to 8.
